# EUROPEAN PATENT APPLICATION

(11) **EP 3 024 025 A1**
(43) Date of publication of application: **25.05.2016**
(21) Application number: 14193929.8
(22) Date of filing: 19.11.2014
(51) Int. Cl.: H01L 23/495

(54) **DIE ARRANGEMENT**

(71) Applicant: NXP B.V., 5656 AG Eindhoven (NL)
(72) Inventor: Lictao, Crispulo, Jr. Estira, Redhill, Surrey RH1 1SH (GB); Fenol, Florante Bergado, Redhill, Surrey RH1 1SH (GB); Heyes, David John, Redhill, Surrey RH1 1SH (GB); Yandoc, Ricardo Lagmay, Redhill, Surrey RH1 1SH (GB)
(74) Representative: Crawford, Andrew

(57) **Abstract**

A die assembly comprising a semiconductor die and a leadframe element having an electrical connection therebetween, the connection comprising one or more spacer elements arranged to define a space between the die and the leadframe, the space around the one or more spacer elements filled with a die attach solder.

## Description

This disclosure relates to a die arrangement. In particular it relates to a die arrangement for or of a power transistor. It also relates to an electronic device including an electronic component formed using the die arrangement. It also relates to a method of controlling solder thickness during manufacture and a method of die assembly.

According to a first aspect we provide a die assembly comprising a semiconductor die and a leadframe element having an electrical connection therebetween, the connection comprising one or more spacer elements arranged to define a space between the die and the leadframe, the space around one or more spacer elements filled with a die attach adhesive.

This is advantageous as the spacer elements can maintain a space between the die and the leadframe which in turn maintains an adhesive thickness between the parts. This may improve the reliability of an electronic component formed of the die assembly. Optionally, the die attach adhesive comprises a die attach solder or another adhesive such as an epoxy adhesive. The die attach adhesive may be electrically conductive.

Optionally, the or each spacer element is electrically conductive. The spacer elements may also be non-conductive, or a combination of conductive and non-conductive may be used.

Optionally, the or each spacer element comprises a bump extending from the leadframe element. In particular, the spacer elements may be deposited on the leadframe prior to attachment of the die to the leadframe with the die attach solder.

Optionally, the spacer element is of a material having a melting point greater than the melting point of the die attach solder. Thus, during a solder reflow operation, the spacer elements retain sufficient rigidity to maintain a spacing between the die and leadframe where they are located, while the solder melts to form the bond between the die and leadframe.

Optionally, a plurality of spacer elements are provided to define the space between the die and the leadframe and the die attach solder extends to fill said space and between the plurality of spacer elements. Thus, the solder may be applied such that it completely fills the space defined by the spacer elements.

Optionally, the or each spacer element is sized to space the die and the leadframe element by between 30 and 55 µm.

According to a second aspect we provide a package containing the die assembly of the first aspect.

The leadframe element may include a lead finger that extends from the package. Optionally, the package includes a floating clip interconnect configured to form a connection to an upper side of the die and extend from the package, the connection between the die and the leadframe element formed on a lower side of the die, opposite the upper side.

According to a third aspect, we provide a method of controlling the thickness of an adhesive between a semiconductor die and a leadframe element or a method of fabricating a die assembly, the method including the steps of;
receiving a leadframe element and a semiconductor die;
applying one or more spacer elements to one or both of the leadframe element and a semiconductor die;
applying die attach adhesive around said one or more spacer elements;
using said die attach adhesive to bond the semiconductor die and leadframe element together.

The die attach adhesive may comprise a die attach solder. The method may include the step of performing a solder reflow operation after applying the die attach solder.

Optionally, the spacer elements are applied only to the leadframe element.

Optionally, the method includes applying a plurality of spacer elements at spaced locations over the leadframe element. Optionally the method include depositing the spacer elements by way of a ball bonding process.

Optionally, the step of applying die attach adhesive comprises printing said adhesive at least around the spacer elements onto the leadframe element.

Optionally, the method includes the step of applying solder and a clip interconnect to an upper surface of the die opposed to the leadframe element.

According to a fourth aspect we provide an electronic device comprising a power transistor, said power transistor formed in the die of the die assembly of the first aspect and the leadframe element may comprises a drain lead for said power transistor.

There now follows, by way of example only, a detailed description of several examples with reference to the following figures, in which:
Figure 1 shows a section through a semiconductor package in including uncontrolled die attach solder between a die and a leadframe.
Figure 2 shows an example die assembly within a package;
Figures 3a-f shows a series of fabrication steps for attaching a die to a leadframe with control of the solder thickness;
Figure 4 shows a flow chart illustrating an example method of controlling die attach solder thickness.

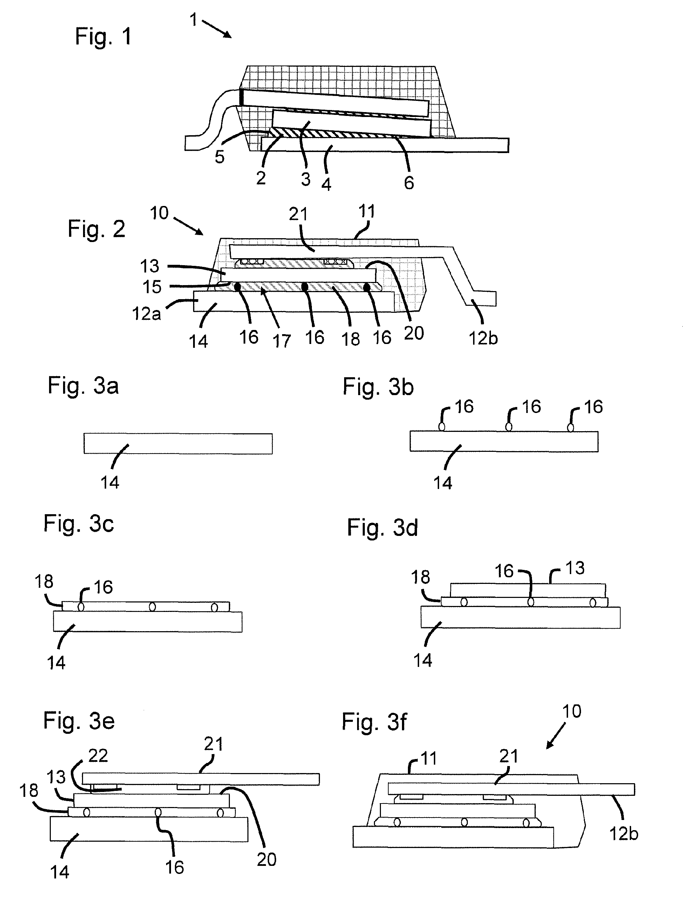

Figure 1 shows a die assembly 1 illustrating an uncontrolled solder bond 2. The die assembly comprises a semiconductor die 3 and a leadframe 4. The die 3 has tilted relative to the leadframe 4 during fabrication, when the solder bond is fluid. Thus, the solder bond 2, which attaches the semiconductor die 3 to the leadframe 4, is wedge shaped and has a thick portion 5 and a thin portion 6. The thickness of the solder bond 2 is important to ensure robustness of the die assembly and the reliability of the electronic component formed by said die assembly.

Figure 2 shows an example die assembly 10 which forms an electronic component. The die assembly is shown within a package 11, which encapsulates the die assembly 10 and includes terminal fingers 12a, 12b that extend from the encapsulation to provide an external connection to/from the electronic component of the die assembly 10.

The die assembly 10 comprises a semiconductor die 13 and a leadframe element 14 having an electrical connection therebetween. In this example, the die assembly forms a power transistor. It will be appreciated that other integrated circuit components may be formed in the die 13. The leadframe element 14 includes the terminal finger 12b and provides for a drain connection to the power transistor. Thus, the drain of the power transistor formed in the die 13 is arranged on a lower side 15 of the die 13. The lower side of the die is therefore electrically connected to the leadframe element 14 which provides the single connection, the drain connection, from the lower side 15. In this example, substantially the whole lower side of the die assembly 3 is connected by an electrically conductive solder connection to the leadframe.

The connection between the semiconductor die 13 and the leadframe element 14 includes a plurality of spacer elements 16 arranged to define a space 17 between the die 13 and the leadframe 14. In this sectional view three spacer elements 16 are shown which define a space between the die 13 and leadframe 14 of substantially 45µm. The space 17 around the one or more spacer elements 16 is filled with a die attach solder 18. It will be appreciated that in other examples adhesives other than solder may be used such as a conductive epoxy adhesive. Thus, the space 17 defined by the spacer elements provides for a minimum thickness of solder between the die 13 and leadframe 14. It will be appreciated that in other embodiments up to or more than one, two, three, four, five, six, seven, eight, nine, ten, eleven or twelve spacer elements may be provided. In this example, there is a total of nine spacer elements 16 extending over the leadframe element in a grid, with only three visible in the sectional view of Figure 2.

The or each spacer element 16 is electrically conductive in this example but non-conductive spacer elements may be used. The spacer elements in this embodiment are of copper or a copper-based solder. Alternatively, the spacer elements may be of gold or gold-based solder. More generally, the spacer elements are of a material having a melting point greater than that of the solder 18 and/or greater than the temperature applied during a solder reflow process step, which is described in more detail below. The spacer elements are substantially spherical, hemispherical or of columns having a rounded head. The spacer elements 16 are sized or extend from the surface of the leadframe element 14, to space the die and the leadframe element, by between 30 and 55 µm. This has been found to ensure a reliable thickness of die attach solder to be placed between the die 3 and the leadframe 14.

On an upper side 20 of the die 13 a clip interconnect 21 is attached. The opposed free end clip interconnect 21 comprises the fingers 12b. The clip interconnect provides an external connection to or from terminals of the device formed in the die 3. In this example, where the die includes a power transistor, the clip interconnect 21 provides a connection to the source and gate terminals of the power transistor. The clip interconnect is bonded, such as by solder, to terminals on the upper surface 20. The spacer elements 16 are particularly advantageous in this arrangement as the clip interconnect cantilevered from the upper surface of the die 13 can cause tilting of the die 13 relative to the leadframe. However, the spacer elements 16 ensure a reliable solder bond.

Figures 3a-f show a series of fabrication steps. Figure 3a shows the receipt of a leadframe 14.

As shown in Figure 3b, spacer elements 16 comprising bumps of copper solder are deposited onto the leadframe 14 in an array. It will be appreciated that where the spacer elements 16 are placed on the leadframe may be different. For example, the spacer elements 16 may be placed preferentially at positions on the leadframe where a clip interconnect overhangs the leadframe. The spacer elements may be applied by printing. The spacer elements may be applied by a ball bonding based process. Ball bonding is typically used to attach a bond wire but involves the bonding of a ball to a substrate, which can be used to form the spacer element bumps. In this example, the spacer elements are solely deposited on the leadframe element but they may be deposited on the lower surface of the die, or a combination of the die and the leadframe.

Figure 3c shows a solder printed on to the leadframe and such that it extends between each of the spacer elements 16 and/or completely surrounds each spacer element 16. The solder may be applied to thickness substantially equal to the height of the spacer elements from the leadframe or slightly higher (i.e. less than 20, 10, 5, 2, or 1% higher, for example). In other embodiments the solder may not surround all of the spacer elements 16.

Figure 3d shows the die 13 attached to the leadframe by the solder including the spacer elements 16.

Figure 3e shows the attachment of the floating clip interconnect 21 to the upper surface 20 of the die 13 by solder 22. The arrangement of Figure 3e then undergoes a solder reflow operation as will be familiar to those skilled in the art. The spacer element 16 are configured to maintain their structural integrity and may not liquefy as much as the solder 18, during the solder reflow operation. Accordingly, the solder 18 thickness between the leadframe 14 and the die 13 is maintained. A flux cleaning step may then be performed.

Figure 3f shows the encapsulation of the die arrangement 10 within a package 11 with the finger(s) of the clip interconnect 21 and the leadframe element 4 forming terminals external to the package 11. The finger 12b may be positioned as required. This method may be used to form an LFPAK power transistor package, such as that provided by NXP Semiconductors.

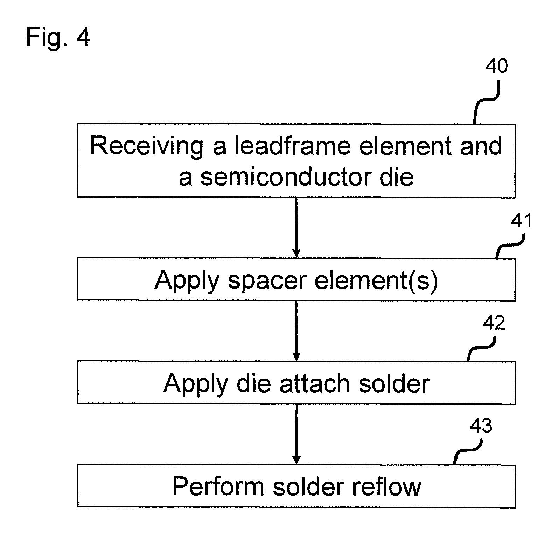

Figure 4 shows a flow chart of a method of fabrication of a die assembly for packaging or, more specifically, a method of controlling the thickness of solder between a semiconductor die and a leadframe element. Step 40 shows receiving a leadframe element and a semiconductor die. Step 41 shows applying one or more spacer elements to one or both of the leadframe element and a semiconductor die. Step 42 shows applying die attach solder around said one or more spacer elements. Step 43 shows performing a solder reflow operation.

Step 41 may include the step of applying a plurality of metal spacer elements at spaced locations over the leadframe element. Step 42 may comprise printing said solder at least around the spacer elements onto the leadframe element which may involve the use of a mask to place the solder around the spacer elements.

As shown in Figure 3e, the method may include the step of applying solder and a clip interconnect to an upper surface of the die opposed to the leadframe element.

The die assembly is particularly suited to the fabrication of power transistors and in particular, but not exclusively, power transistors of LFPAK type. The power transistors may be used in a variety of electronic devices and, by virtue of the method, have good reliability. An electronic device, such as a mobile telephone communication mast or amplifier therefore, may comprise a power transistor having the die arrangement 10.

## Claims

1. A die assembly comprising a semiconductor die and a leadframe element having an electrical connection therebetween, the connection comprising one or more spacer elements arranged to define a space between the die and the leadframe, the space around one or more of the spacer elements filled with a die attach adhesive.

2. A die assembly according to claim 1, in which the or each spacer element is electrically conductive.

3. A die assembly according to claim 1 or claim 2, in which the or each spacer element comprises a bump extending from the leadframe element.

4. A die assembly according to any one of claims 1 to 3, in which the die attach adhesive comprises a die attach solder and spacer element is of a material having a melting point greater than the melting point of the die attach solder.

5. A die assembly according to claim 1, in which a plurality of spacer elements are provided to define the space between the die and the leadframe and the die attach adhesive extends to at least partially fill said space between the plurality of spacer elements.

6. A die assembly according to claim 1, in which the or each spacer element is sized to space the die and the leadframe element by between 30 and 55 µm.

7. A package containing the die assembly of any one of claims 1 to 6.

8. A package according to claim 7, in which the leadframe element includes a lead finger that extends from the package.

9. A package according to claim 8, in which the package includes a floating clip interconnect configured to form a connection to an upper side of the die and extend from the package, the connection between the die and the leadframe element formed on a lower side of the die, opposite the upper side.

10. A method of controlling the thickness of solder between a semiconductor die and a leadframe element, the method including the steps of;
receiving a leadframe element and a semiconductor die;
applying one or more spacer elements to one or both of the leadframe element and a semiconductor die;
applying die attach adhesive around said one or more spacer elements;
using said die attach adhesive to bond the semiconductor die and leadframe element together.

11. A method according to claim 10, in which the spacer elements are applied to the leadframe element.

12. A method according to claim 10, in which the method comprises applying a plurality of spacer elements at spaced locations over the leadframe element.

13. A method according to claim 10, in which the die attach adhesive comprises die attach solder and the step of applying die attach solder comprises printing said solder at least around the spacer elements onto the leadframe element.

14. A method according to claim 10, in which the method includes the step of applying solder and a clip interconnect to an upper surface of the die opposed to the leadframe element.

15. An electronic device comprising a power transistor, said power transistor formed in the die of the die assembly of any one of claims 1 to 6 and the leadframe element comprises a drain lead for said power transistor.
